(19) Europäisches Patentamt
European Patent Office
Office européen des brevets

(11) EP 2 306 626 A1

(12) EUROPEAN PATENT APPLICATION

(43) Date of publication:
06.04.2011 Bulletin 2011/14

(51) Int Cl.:
H02M 3/07 (2006.01)          H01L 21/02 (2006.01)
H01L 29/94 (2006.01)

(21) Application number: 09171834.6

(22) Date of filing: 30.09.2009

(84) Designated Contracting States:
AT BE BG CH CY CZ DE DK EE ES FI FR GB GR
HR HU IE IS IT LI LT LU LV MC MK MT NL NO PL
PT RO SE SI SK SM TR
Designated Extension States:
AL BA RS

(71) Applicant: NXP B.V.
5656 AG Eindhoven (NL)

(72) Inventors:
• Villar Pique, Gerard
  Redhill, Surrey RH1 1DL (GB)

• Warmerdam, Leo
  Redhill, Surrey RH1 1DL (GB)
• Roozeboom, Freddy
  Redhill, Surrey RH1 1DL (GB)
• Bergveld, Hendrik Johannes
  Redhill, Surrey RH1 1DL (GB)

(74) Representative: Ashton, Gareth Mark et al
NXP Semiconductors
Intellectual Property Department
Betchworth House
67-65 Station Road
Redhill, Surrey RH1 1DL (GB)

(54) **Voltage conversion circuit**

(57)     Disclosed is a voltage conversion circuit (10) comprising a flying capacitor (12) formed in or on a semiconductor substrate (26), said flying capacitor having a first electrode selectively coupled to an input node for connecting the flying capacitor between different voltage levels ($V_{bat}$; $V_2$) and a second electrode selectively coupled to an output node ($V_{out}$), wherein at least one of the first electrode and the second electrode form a first region of a parasitic capacitance (110), the second region of which is formed by a part of the substrate (or any other conductor at constant voltage), the voltage conversion circuit further comprising a biasing element (80) for increasing the impedance of the conductive path between the first region and the second region, wherein the biasing element is selected from the group consisting of a bias voltage source, a bias resistor and a series-connected capacitor, which may be provided by an additional PN junction.

FIG. 24

**Description**

FIELD OF THE INVENTION

The present invention relates to a voltage conversion circuit comprising a flying capacitor formed in or on a semiconductor substrate, said flying capacitor having a first electrode selectively coupled to an input node for connecting the flying capacitor between different voltage levels and a second electrode selectively coupled to an output node.

BACKGROUND OF THE INVENTION

Voltage conversion circuits are commonly used in e.g. integrated circuit (IC) technology to convert a supply voltage to an internal voltage of the IC. Such a voltage conversion may be an increase (voltage multiplier), a decrease (voltage divider) or an inversion (voltage inverter) of the supply voltage. At present, there are three main concepts in use in integrated circuit devices for voltage-level conversion. Inductive converters based on the use of at least one inductor to temporally store the energy being converted, linear regulators also known as Low voltage Drop Out (LDO) regulators, which implement some variable resistor to generate output voltage regulation and switched-capacitor converters in which the energy is stored in one or more flying capacitors.

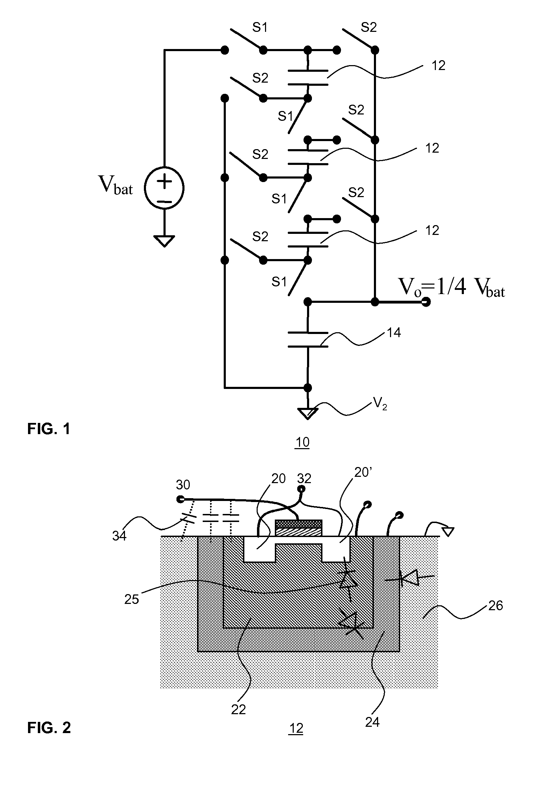

As an example, a switched-capacitor converter 10 providing a ¼ voltage conversion ratio is shown in Fig. 1. The switched-capacitor converter 10 has three flying capacitors 12 that are selectively connected between a voltage source $V_{bat}$ for providing an input voltage $V_{in}$ and which may be a battery, and an output node $V_o$ for providing the converted voltage. Switches S1 and S2, e.g. switching transistors, are provided to alternately connect the flying capacitors 12 between $V_{bat}$ and a fixed lower voltage level $V_2$, e.g. ground in the first (charging) mode in which switches S1 are enabled, and between the output node $V_o$ and the lower voltage potential $V_2$ in the second (discharging) mode in which $V_o$ is provided with the converted voltage. A smoothing capacitor 14 is provided to smooth the pulsed output voltage of the voltage conversion circuit 10.

Regarding their theoretical maximum efficiency, inductive converters are capable of producing 100% power efficiency, while the efficiency of LDOs is limited by the ratio $V_{out}/V_{in}$. This usually makes LDOs less efficient, especially in case of large differences between $V_{in}$ and $V_{out}$. In case of switched-capacitor converters, the theoretical maximum efficiency is related to $V_{in}$ and $V_{out}$ as well as their open-circuit conversion ratio, which makes them more efficient than LDOs but less efficient than inductive converters.

For these reasons, high-power converters have usually been implemented by means of inductive converters, whereas low-power converters to be integrated have usually been based on LDO structures because of the avoidance of the cumbersome integration of large size inductors. The ideal application domain of switched-capacitor voltage converters has been more difficult to define because of their drawbacks in both aforementioned fields; either switched-capacitor voltage converters do not achieve sufficient efficiency, or the size requirements of the flying capacitors prohibits easy integration. This has led to a less wide-spread application of switched-capacitor voltage converters compared to the other voltage-converter types.

However, with the increasing demand of higher power processing for increasingly smaller systems, for which the size of the system is a key factor, an increasing interest in miniaturized switching power converters, based either on inductors or on flying capacitors, has arisen because of their higher efficiency compared to LDOs and their possibility to boost or invert input voltages, which cannot be accommodated by LDOs. For this reason, switched-capacitor converters are becoming frequently considered as the preferred implementation choice, because at the relevant feature sizes, inductive converters start to experience a degradation of their power efficiency values due to the (lack of) quality of the integrated inductors and the increased complexity of the implementation of the so-called Discontinuous Conduction Mode (DCM), which is especially relevant for ultra-low power levels.

In other words, switched-capacitor voltage converters should be capable, at least below certain power levels, to produce power efficiencies higher than LDOs and integrated inductive converters in completely integrated systems. For this reason, switched-capacitor converters have become a more appealing design choice, not in the least because these converters still have the ability to generate voltage levels above the voltage supply or below the ground on the considered scale of technology.

One of the main challenges for improving the power efficiency of switched-capacitor power converters is the reduction of the energy losses related to the parasitic coupling capacitances from each terminal of the flying capacitors, i.e. the parasitic capacitances associated with the "top" plate and the "bottom" plate of the flying capacitor, respectively. Due to their planar implementation, usually, the parasitic capacitance associated with the bottom plate is much larger than the top plate parasitic capacitance, the latter usually being due to the interconnections of the voltage conversion circuit with other devices. In other words, most energy losses are due to the bottom-plate parasitic capacitance.

Indeed, the presence of these parasitic capacitances, and in particular the parasitic capacitance associated with the bottom electrode, can be the major source of switching losses in a switched-capacitor voltage conversion circuit.

$$P_T = f_s \sum_n C_i \Delta V_i^2$$

This becomes a key issue in integrated circuit designs, especially for designs having submicron feature sizes, because the voltage conversion circuits in such design typically have to operate at high switching frequencies to produce sufficient currents at the desired voltage. This problem is particularly important in integrated solutions such as System-In-Package or monolithic systems, where the corresponding reduction of feature sizes and distances increases the relative value of these parasitic capacitances compared to the capacity of the flying capacitors.

This problem typically occurs regardless of the chosen implementation of the flying capacitors, as will be demonstrated by the following examples. In FIG. 2, the flying capacitor 12 is implemented as a MOS transistor in a triple-well technology. The top plate of the flying capacitor 12, i.e. the plate furthest away from the substrate, is formed by the gate electrode connected to a terminal 30, whereas the bottom plate of the flying capacitor 12, i.e. the plate closest to the substrate is formed by shorting the source region 20 and drain region 20' by means of a shared terminal 32. The source region 20, drain region 20' and the channel region in between the source region 20 and drain region 20' are placed in a bulk p-type material 22 that is embedded in an n-well 24 formed in p-type substrate 26.

This flying capacitor 12 exhibits two types of parasitic capacitances; a parasitic capacitance 34 between the top plate and the substrate 26, and a parasitic capacitance embodied by a reverse biased p-n junction diode 25 between the bottom plate of the flying capacitor 12 formed by the source region 20 and drain region 20' on the one hand and the bulk p material 22 on the other hand, where the capacitance is formed by the amount of charge carriers the depletion region of the diode can hold. Typically, the capacitance of parasitic capacitance 34 is much smaller than that of the p-n junction diode 25. Also, the parasitic capacitance 34 is largely independent of the applied voltage whereas the capacitance of the p-n junction diode 25 is not.

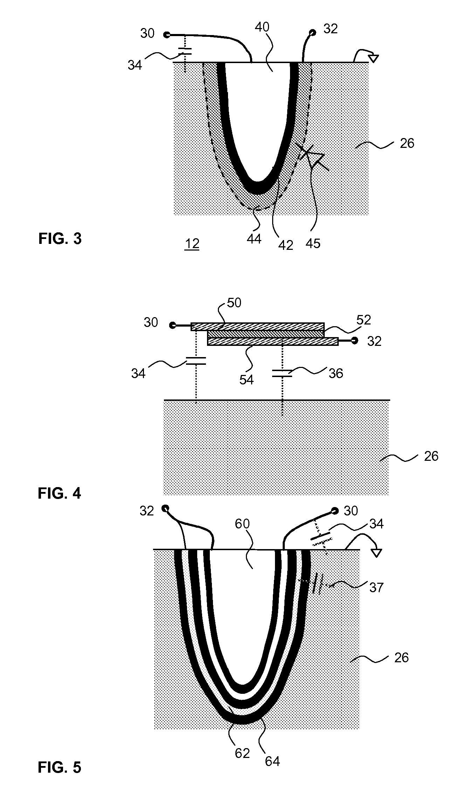

Another embodiment of a flying capacitor 12 is depicted in FIG. 3, in which the flying capacitor 12 is a trench MOS capacitor. The bottom terminal is formed by an N$^+$ doped trench 44 in the p-type substrate 26, which is separated from the trench 40 forming the top plate by a dielectric trench 42. A bottom-plate parasitic capacitance is formed by the reverse-biased p-n junction diode 45, which capacitance is dependent of the applied voltage, in contrast to the much smaller top-plate capacitance 34.

Such capacitors can achieve a capacitive density of up to 80 nF/mm$^2$. In order to form such high-density capacitors, pores are dry-etched in a high-resistivity silicon substrate 26. The bottom electrode 44 of the MOS capacitor structure is formed by making the pore walls of the structure highly conductive using an n+-dopant. The dielectric layer 42 may be formed by an ONO (Oxide-Nitride-Oxide) layer, whereas the top electrode 40 may be formed by filling the pores with n-type in-situ-doped poly silicon. The top and bottom electrodes may be subsequently contacted with first-metal-layer aluminum, i.e. terminals 30, 32.

FIG. 4 depicts another possible embodiment of a flying capacitor 12, in which the flying capacitor 12 is implemented as a metal-insulator-metal (MIM) capacitor in the metallization stack of an IC. The top electrode 50 and bottom electrode 54 are formed in the conductive layers of the metallization stack, e.g. metal layers or poly-Si layers, and are separated by a dielectric layer 52. Parasitic capacitances 34, 36 are formed between the respective electrodes and the substrate 26. These parasitic capacitances are largely independent of the applied voltage. The MIM capacitors as shown in FIG. 4 typically achieve a capacitive density of a few nF/mm$^2$.

FIG. 5 depicts an embodiment of a multilayer atomic-layer deposited trench MIM capacitor. A more detailed description of such a capacitor can for instance be found in WO2007/054858 A2. The flying capacitor 12 in FIG. 5 comprises a plurality of conductive layers 62 separated by dielectric layers 64 and a further trench-filling plug 60. The plug 60 and at least the outer trench conductive layer 62 form the bottom electrode of the flying capacitor 12, with at least one of the intermediate conductive trench layers of the flying capacitor 12 forming the top electrode of the capacitor. It should be understood it is not necessary that the outer trench conductive layer and the plug belong to the same electrode of the capacitor. This depends on the number of layers being odd or even. A relatively small and existent-voltage-independent parasitic capacitor 34 and a larger parasitic capacitance 37 formed by the outermost trench conductive layer 62, the outermost dielectric layer 64 and the substrate 26 are typically present.

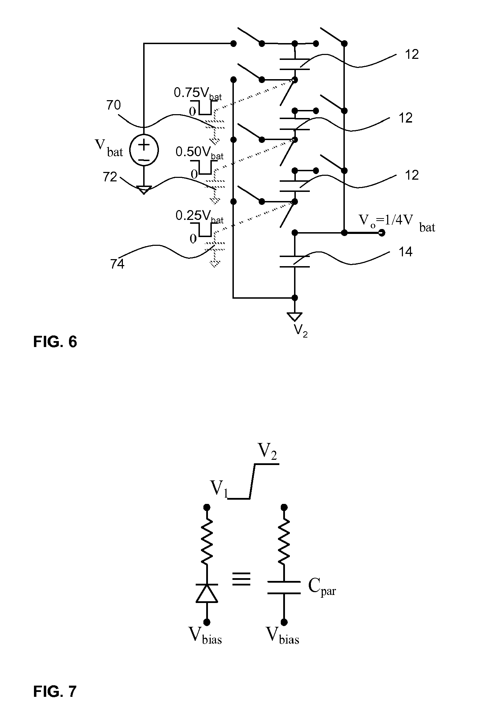

From the foregoing, it should be apparent that all capacitor-based implementations of voltage conversion circuits suffer from efficiency losses due to the fact that the aforementioned parasitic capacitances are also charged each time the flying capacitors 12 of the voltage conversion circuit 10 of FIG. 1 are charged. This is schematically demonstrated in FIG. 6, where the parasitic capacitances 70, 72 and 74 that are conductively connected to respective switching nodes of the flying capacitors 12 are depicted together with the voltage applied to them.

For parasitic capacitances that have capacities independent of the applied voltage, the power losses $P_T$ corresponding to a number n of parasitic capacitances can be computed as:

$$P_T = f_s \sum_n C_i \Delta V_i^2$$

where $f_s$ is the switching frequency, $C_i$ is each parasitic capacitance value and $\Delta V_i$ is the corresponding voltage excursion that each particular capacitance is exposed to during its charging process. In case of voltage dependent capacitances, the integral of the product $c_i v_i dv_i$ should be computed for each capacitor along the charge process, added and multiplied by $f_s$, to get the overall power losses.

The power losses caused by parasitic capacitances in the order of 0.5% or 2% of their corresponding flying-capacitor value can cause a reduction of the total efficiency by about 20% for a switched-capacitor converter 10 including three flying capacitors 12. It will be appreciated that these values also depend significantly on the various design parameters of such a voltage conversion circuit.

Y.K. Ramadass et al. in "Voltage Scalable Switched Capacitor DC-DC Converter for Ultra-Low-Power On-Chip Applications", IEEE Power Electronics Specialist Conference (PESC) 2007, pages 2353-2359 disclose a flying-capacitor-based voltage converter for which the switching sequence is modified to reduce the power losses caused by the presence of parasitic capacitances. This solution has several drawbacks, such as the requirement of a higher switching frequency to achieve the same output level, which only marginally improves the efficiency of the voltage converter at the cost of significant additional design complexity.

SUMMARY OF THE INVENTION

The present invention seeks to provide a flying-capacitor-based voltage conversion circuit having an improved efficiency.

According to an aspect of the present invention, there is provided a voltage conversion circuit comprising a flying capacitor formed in or on a semiconductor substrate, said flying capacitor having a first electrode selectively coupled to an input node for connecting the flying capacitor between different voltage levels and a second electrode selectively coupled to an output node, wherein at least one of the first electrode and the second electrode form a first region of a parasitic capacitance, the second region of which is formed by a part of a constant voltage conductor such as the substrate or any other constant voltage conductor in the chip, the voltage conversion circuit further comprising a biasing element for increasing the impedance of the conductive path between the first region and the second region, wherein the biasing element is selected from the group consisting of bias voltage source, a bias resistor and a series-connected capacitor (coming from a PN junction or not).

The application of a suitable bias to one of the substrate-based 'electrodes' of the parasitic capacitance increases the impedance of the conductive path between the two electrodes of the parasitic capacitor(s) of the voltage conversion circuit such that the amount of charge leaking away from the flying capacitor to this parasitic capacitor is reduced, thus reducing the power losses and improving the efficiency of the voltage conversion circuit of the present invention.

The flying capacitor(s) of the voltage conversion circuit of the present invention may be implemented in any suitable manner. For instance, the flying capacitor may be formed by a transistor in the substrate, said first electrode comprising the gate structure of said transistor and the second electrode comprising the source and drain regions of said transistor. Alternatively, one of the electrodes of the flying capacitor may be formed by an isolated N or P well.

Alternatively, the flying capacitor(s) may be a trench capacitor in said substrate, in which the second electrode of the trench capacitor may advantageously comprise a pair of conductive trench layers, and wherein the first electrode comprises an intermediate conductive trench layer in between said pair, the conductive trench layers being separated from each other by respective dielectric layers.

As a further alternative, the flying capacitor(s) may be formed in a metallization structure on the substrate, said first and second electrodes being respective metal layers separated by a dielectric layer in said metallization structure.

In an embodiment, said part of the substrate is of a first conductivity type, said part being embedded in a further part of the substrate of an opposite conductivity type, wherein the biasing element being a bias voltage source is connected to said further part. In this embodiment, a further reverse bias diode may be formed between the part and the further part of the substrate, which is biased a direction opposite to the p-n junction diode-based parasitic capacitance. This effectively increases the impedance of the current path from the flying capacitor to ground, thus improving the efficiency of the voltage conversion circuit of the present invention. This embodiment is particularly effective for parasitic capacitances that are sensitive to the voltage applied to the voltage conversion circuit.

In a further embodiment, the voltage conversion circuit may further comprise a further bias voltage source connected to said part of the substrate. This may for instance be advantageous if the flying capacitor is implemented in a triple well, in which case both the well and the surrounding substrate may be biased to further reduce the capacitance of the p-n junction between the capacitor and the bulk material in which it has been formed.

In an alternative embodiment, said part of the substrate is of a first conductivity type, said part embedding a further part of the substrate, said further part being of an opposite conductivity type, and wherein the bias voltage source is connected to said further part. In other words, a doped region of opposite conductivity type to the substrate may be formed as a terminal for the bias voltage supply such that a reverse bias p-n junction is formed between the part and further part of the substrate, thus increasing the impedance of leakage current paths from the flying capacitor to the substrate.

In a further advantageous embodiment, said part of the substrate may be coupled to the bias voltage source via a resistor. This is particularly advantageous in case the parasitic capacitance is largely independent of the voltage applied to the flying capacitors, where this embodiment provides a more efficient reduction of the power loss compared to the application of a bias voltage only.

Alternatively, the parasitic capacitance may be coupled to the bias voltage source via one or more series-connected additional capacitors.

The voltage conversion circuit of the present invention may comprise any number of flying capacitors, e.g. a plurality of flying capacitors. In an embodiment, each flying capacitor is conductively coupled to a part of the substrate via a respective parasitic capacitance, and wherein each parasitic capacitance is coupled to a respective bias voltage source. This has the advantage that the power losses associated with the respective parasitic capacitances are separately reduced, thereby achieving more optimal reductions.

The voltage conversion circuit of the present invention may be advantageously included in an integrated circuit, e.g. a monolithic IC, a system-in-package and so on. This integrated circuit may be advantageously included in any suitable electronic device, e.g. a consumer electronics device, a mobile communication device, a medical device and so on.

BRIEF DESCRIPTION OF THE DRAWINGS

Embodiments of the invention are described in more detail and by way of non-limiting examples with reference to the accompanying drawings, wherein

FIG. 1 depicts a prior art capacitor-based voltage conversion circuit;
FIG. 2-5 depict prior art implementations of a flying capacitor for such a voltage conversion circuit;
FIG. 6 depicts the problem associated with the prior art capacitor-based voltage conversion circuit of FIG. 1,
FIG. 7 conceptually depicts an aspect of an embodiment of the voltage conversion circuit of the present invention;
FIG. 8 depicts a graph of the bias-voltage-dependent parasitic capacitance of the embodiment of the voltage conversion circuit depicted in FIG. 7;
FIG. 9 conceptually depicts an aspect of another embodiment of the voltage conversion circuit of the present invention;
FIG. 10 depicts a graph of the RC-dependent parasitic capacitance of the embodiment of the voltage conversion circuit depicted in FIG. 7;
FIG. 11-15 schematically depict various exemplary embodiments of a part of the voltage conversion circuit of the present invention;
FIG. 16 schematically depicts an embodiment of the voltage conversion circuit of the present invention;
FIG. 17 schematically depicts a graph of the efficiency of the voltage conversion circuit depicted in FIG. 16 as a function of applied bias voltage;
FIG. 18 and 19 depict further embodiments of the voltage conversion circuit of the present invention;
FIG. 20 schematically depicts a graph of the efficiency of the voltage conversion circuits depicted in FIG. 18 and 19 as a function of applied bias resistance;
FIG. 21 and 22 schematically depict yet further embodiments of the voltage conversion circuit of the present invention;
FIG. 23 depicts a graph of the efficiency of the voltage conversion circuits depicted in FIG. 21 and 22 as a function of P-N junction size;
FIG. 24 schematically depicts another embodiment of the voltage conversion circuit of the present invention; and
FIG. 25 schematically depicts a graph of the efficiency of the voltage conversion circuit depicted in FIG. 24 as a function of applied bias resistance.

DETAILED DESCRIPTION OF THE EMBODIMENTS

It should be understood that the Figures are merely schematic and are not drawn to scale. It should also be understood that the same reference numerals are used throughout the Figures to indicate the same or similar parts.

The present invention is based on the realization that power losses in capacitor-based voltage conversion circuits can be reduced by diminishing the impact of the parasitic capacitances between the electrodes of the flying capacitors on the one hand and parts of the electronic device, e.g. an IC or SiP, that are conductively coupled to these electrodes on the other hand. These parts typically exhibit a lower voltage than the electrode of the flying capacitor. The general inventive concept of the present invention is to increase the impedance between the switching nodes of the flying capacitor(s) of the voltage conversion circuit and the ground potential or any other voltage level, in order to reduce the amount of current flowing from the flying capacitor to the part of the device exhibiting this voltage level.

It is noted that the biasing techniques of the present invention are conceptually different to well-known body biasing, in which reduces leakage currents of digital circuits are reduced by biasing bulk voltages of transistors. Body biasing is a DC effect, whereas the biasing techniques of the present invention rely on an AC current effect through a parasitic capacitance due to switching of a capacitive converter and the reduction of this AC current by increasing the impedance in the current path.

Three main strategies are considered to increase the impedance between the switching nodes of the flying capacitor(s) of the voltage conversion circuit and the ground potential or any other voltage level:

- reduction of the capacitance value of the parasitic capacitance $C_{par}$;
- reduction of the charge loss by series connecting $C_{par}$ to a bias voltage source via a bias resistor; and
- reduction of the charge loss by series connecting $C_{par}$ to a bias voltage source via one or more additional capacitances, which may be provided by additional PN junctions.

Combinations of these main strategies are also feasible, as will be explained in more detail later.

FIG. 7 schematically depicts the first main strategy of the present invention. In case of parasitic capacitances $C_{par}$ due to a reverse-biased PN junction, e.g. as depicted in the capacitor implementations shown in FIG. 2 and 3, the capacitance value can be changed by means of modifying the bias voltage $V_{bias}$ applied to the corresponding bulk, well or substrate, or combinations thereof.

Taking into account the circuit of Fig. 7, which also shows a resistor corresponding to the circuitry of the switched-capacitor voltage conversion circuit 10 where the losses are produced. Although it is noted that switching losses of the size 1/2CV² even occur when this resistor is very small, the effect of this resistor will be neglected in the rest of this evaluation for the sake of simplicity. The charge $Q_T$ required to fully charge the junction capacitor from $V_1$ to $V_2$ is:

$$Q_T = 2C_{j0}\Phi_0\left[\sqrt{1 + \frac{V_2 - V_{bias}}{\Phi_0}} - \sqrt{1 + \frac{V_1 - V_{bias}}{\Phi_0}}\right]$$

wherein $C_{j0}$ is the depletion capacitance at 0V of reverse biasing voltage and $\Phi_0$ is the built-in junction potential

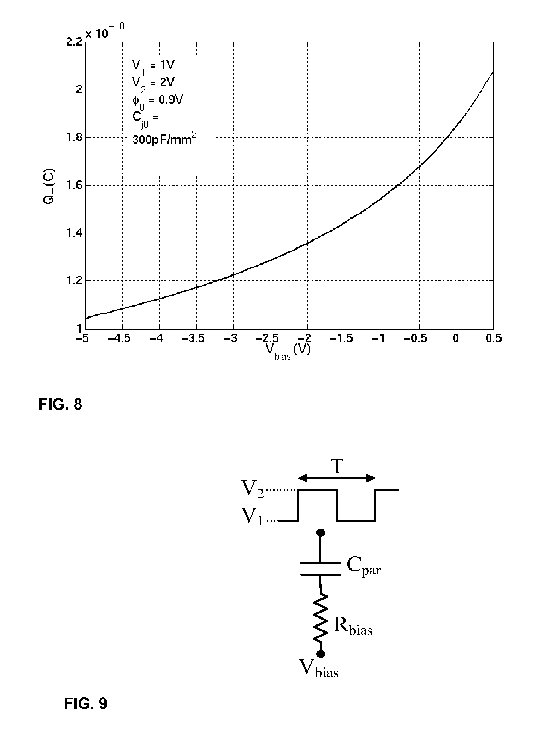

It should be observed that this expression does not present a minimum value $Q_T$ as a function of bias voltage, but it keeps on decreasing as $V_{bias}$ becomes more negative. This behavior is demonstrated in FIG. 8, which depicts the required amount of charge $Q_T$ as a function of applied bias voltage. Hence, it can be concluded that the application of an as low as possible bias voltage $V_{bias}$ without reaching any of the breakdown voltages of the technology would reduce the coupling capacitance $C_{par}$ and the associated power losses, thus increasing the power efficiency of the capacitor-based voltage conversion circuit 10. It will be appreciated that this strategy will be less effective when the parasitic capacitances are not significantly dependent on the applied voltage, as for instance is the case when using MIM capacitors as shown in FIG. 4 or multilayer-ALD MIM capacitors as shown in FIG. 5 as flying capacitors 12.

The power losses associated with parasitic capacitances that are largely insensitive to the voltage applied to the voltage conversion circuit 10 may be reduced by means of the second main strategy of the present invention, which is shown in FIG. 9. This strategy is based on the assumption that a well-defined parasitic capacitance is present, which is connected to any bias voltage source by means of a resistor $R_{bias}$ or any other suitable impedance. This arrangement is intended to reduce the amount of charge flowing through the parasitic capacitance independent of the nature of the parasitic capacitance, i.e. either sensitive or insensitive to the voltage applied to the voltage conversion circuit 10. Care has to be taken that the time constant RC of the RC circuit formed by the parasitic capacitance and the bias resistor $R_{bias}$ is large enough compared to the switching period T.

Only the energy required to charge the capacitance $C_{par}$, i.e. raise its voltage, is considered because this capacitance is typically discharged by a different mechanism, which usually is a short-circuit to ground or any other equivalent voltage source. Although any suitable biasing voltage may be applied, for the sake of simplicity 0V is considered in the following evaluation. Moreover, a linear capacitor $C_{par}$ is considered for the sake of simplicity. Consequently, the energy $E_G$ provided by the voltage source $V_{bias}$ in case of a 50% duty-cycle switching signal between $V_1$ and $V_2$ is:

$$E_G = V_2(V_2 - V_1)C_{par}\left[1 - e^{\frac{-T}{2R_{bias}C_{par}}}\right]$$

Thus, in case of fully charging and discharging the capacitor ($T \gg 2R_{bias}C_{par}$) the total amount of consumed energy is:

$$E_{G\_max} = V_2 (V_2 - V_1) C_{par}$$

However, this maximum value can be reduced by increasing the $R_{bias}C_{par}$ time constant compared to the switching period.

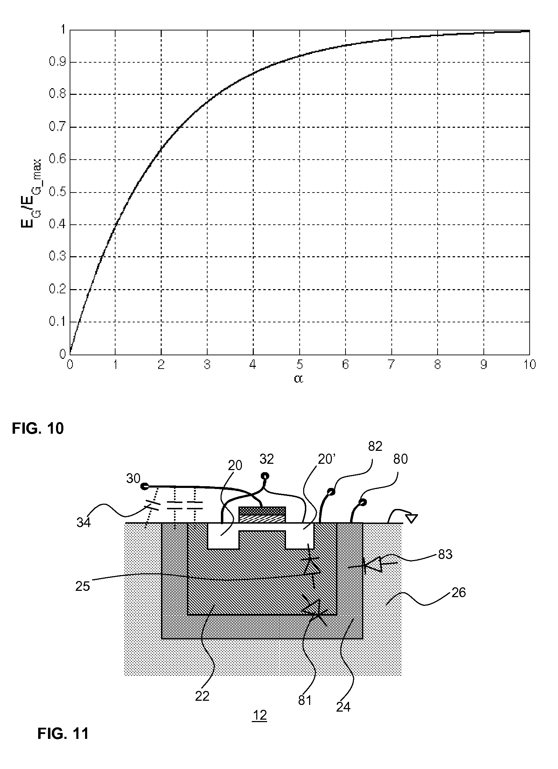

Defining the ratio the optimum reduction in energy losses can be found as depicted in FIG. 10, in which the reduction in energy loss as a function of $\alpha$ is depicted. As observed in FIG. 10, for $T=R_{bias}C_{par}$ ($\alpha=1$) only 40% of the maximum losses are experienced, whereas for $T=0.2R_{bias}C_{par}$ ($\alpha=0.2$), the related losses are reduced by roughly 90% compared to the maximum energy loss in case of the absence of the biasing measures ($E_G/E_{G\ max}=0.1$). Hence, it can be seen that for relatively small values of $\alpha$, a significant reduction of power loss via the parasitic capacitance can be achieved.

It is noted that these results could lead to the conclusion that a large value of $C_{par}$ could help to reduce losses because it helps creating a large time constant. However, it is pointed out that $E_{G-max}$ is proportional to the parasitic capacitance such that the absolute value of the energy losses is proportional to the value of $C_{par}$. Similarly, increasing the switching frequency of the voltage conversion circuit 10 is also not advisable because the power losses through $C_{par}$ are proportional to the switching frequency, such that such an increase would also increase the switching losses of the voltage conversion circuit 10. It should be appreciated that in order to reduce the power losses associated with the charging of $C_{par}$, the value of $R_{bias}$ should be increased. This approach is capable of significantly reducing the energy losses related to the parasitic capacitance, as long as the remaining parasitic impedances in parallel with $C_{par}$ and $R_{bias}$ are negligible. The only drawback of this solution is the additional area required to implement the resistor.

The third main strategy of the present invention involves the provision of one or more additional series-connected capacitors between the parasitic capacitance and the bias voltage source. The main concept behind this approach is that the series connection of two or more capacitors results in an overall capacitance value that is lower than the individual capacitance of any of the series-connected capacitors. The additional capacitors may be both linear and non-linear capacitors. Thus, in most of the cases it is very convenient to implement them by means of additional reverse-biased PN junctions.

In a back-to-back connection of two (PN junction) diodes, it can be assumed that both diodes are reverse-biased since in case that the anode gets a higher voltage than any of the cathodes (PN junction forward-biased), the accumulated charge will flow through the PN junction until it gets reverse-biased again. The same reasoning holds for the face-to-face connection of two diodes.

In case of a linear parasitic capacitance $C_{par}$, if the additional capacitor is implemented by means of a PN junction, it has to be connected in a way that makes the PN junction reverse-biased. This may for instance imply that the bias voltage has to be provided at a particular value to achieve this reverse-biasing.

The various implementations of the flying capacitors as depicted in FIG. 2-5 may be amended as follows to achieve the formation of additional series capacitances, as will be demonstrated below. In FIG. 11, the MOS transistor-based implementation of the capacitor of FIG. 2 is amended by the provision of a first bias voltage source 82 to the bulk material 22 and a second bias voltage source 80 to the n-well 24 for reverse biasing the PN junction diodes 81, 83 that are intrinsically present in the triple-well design as shown in FIG. 2.

Furthermore, it is noted that as a particular case, leaving the wells unconnected, i.e. not connecting bias sources 82 and 80, would result in the lowest parasitic capacitance value, because of the series connection of the 3 reverse biased parasitic diodes. In case of using NMOS transistors as capacitors in an isolated DNW, traditionally the corresponding P-well and DNwell have been connected to the lowest and highest voltage levels that they may experience, respectively. Usually these levels are GND and $V_{dd}$, respectively. The main reason for this is to control and guarantee the characteristics of those transistors, at the cost of increasing their parasitic capacitances.

However, since in the present invention only the gate capacitance is of relevance (as a flying capacitor), these wells can be left unconnected to reduce the parasitic capacitances. Although this will affect the characteristics of the devices, they will still behave as capacitor as required. Obviously, the same principle applies to pMOS transistor-based capacitors in an Nwell. Additionally, in some specific cases it could be even possible to leave the complete substrate unconnected, to further reduce the parasitic capacitances.

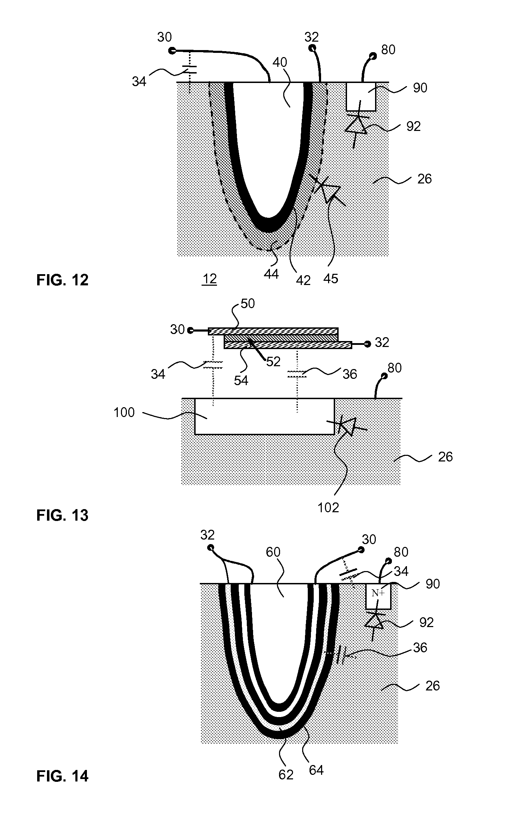

FIG. 12 schematically depicts the amended trench-MOS capacitor of FIG. 3, which has been amended by the provision of an additional diffusion 90 of a diffusion type opposite to the diffusion type of the substrate 26 such that an additional PN junction 92 is formed. The additional diffusion 90 is connected to the bias voltage source 80 for reverse biasing the additional PN junction 92 such that the parasitic capacitance 45 and the additional PN junction 92 are arranged back-to-back for the aforementioned reasons.

FIG. 13 schematically depicts the amended MIM capacitor of FIG. 4, which has been amended by the provision of an additional diffusion 100 of a diffusion type opposite to the diffusion type of the substrate 26 such that an additional PN junction 102 is formed. In this embodiment, the substrate 26 is connected to the bias voltage source 80 for reverse biasing the additional PN junction 102. This embodiment assumes that the substrate 26 is not shared with other circuitry that may require the provision of a different voltage through the substrate.

FIG. 14 schematically depicts the amended multi-layer trench-MIM capacitor of FIG. 5, which has been amended by the provision of an additional diffusion 90 of a diffusion type opposite to the diffusion type of the substrate 26 such that an additional PN junction 92 is formed. The additional diffusion 90 is connected to the bias voltage source 80 for reverse biasing the additional PN junction 92 such that the parasitic capacitance 36 is series-connected to the reverse-biased diode 92.

It will be appreciated that although in the above examples the additional series-connected capacitances are implemented by means of PN junction diodes, any suitable implementation of such a series-connected capacitance may be chosen. Also, when more substrate layers are available, a larger number of PN diodes may be series-connected, thus even further reducing the total capacitance value of the capacitor chain, which translates to a reduction in the power losses experienced by the voltage conversion circuit 10.

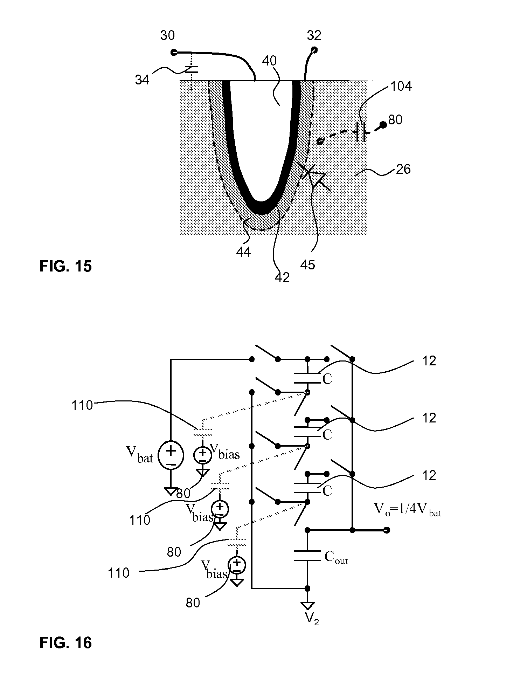

FIG. 15 depicts a special example of an additional series-connected capacitance in accordance with an embodiment of the present invention, in which the substrate 26 is not connected to a bias voltage source, i.e. is left floating (note the absence of the connection of the substrate 26 to ground). Consequently, a parasitic capacitance 104 series-connected to the parasitic capacitance 45 of the flying capacitor can be coupled to any voltage reference. The value of this coupling capacitance will depend on how well isolated the substrate 26 is from other circuits (not shown). This concept is especially feasible for implementations in which the substrate 26 is not shared with other circuitry.

It is reiterated that the main three concepts for increasing the impedance between the switching nodes of the flying capacitor(s) of the voltage conversion circuit and the ground potential or any other voltage level may be combined to further improve the efficiency of the voltage conversion circuit 10.

Various embodiments of the present invention have been simulated to demonstrate the efficiency of the proposed solutions. These simulations have been based on the voltage conversion circuit 10 of FIG. 1, i.e. a ¼ voltage conversion circuit. Unless specified otherwise, the following values have been used in these simulations: switching frequency $f_s$=15MHz, the switches' impedance $R_{sw}$ = 50Ω, the capacitance of each flying capacitor 12 is C = 10pF, $V_{bat}$=4V, the load impedance $R_{load}$=10kΩ and the capacitance of the smoothing capacitor 14 is $C_{out}$=100pF. In the following FIGS., the equivalent circuit of the simulated embodiments and the simulation results are presented.

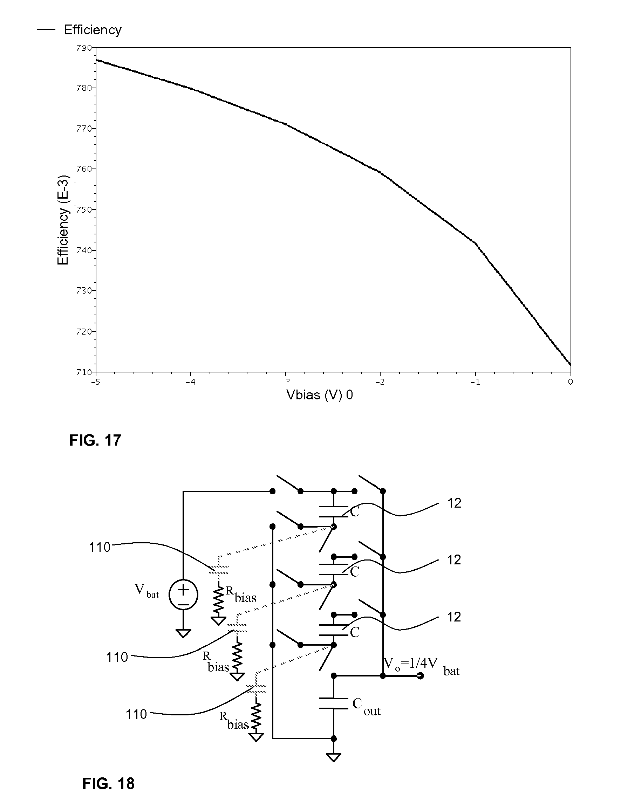

FIG. 16 depicts the embodiment in which the parasitic capacitances 110 associated with the bottom electrode of each flying capacitor 12 is connected to a different bias voltage source 80. To this end, the respective bottom electrodes may be placed in different isolated wells in the substrate 26. In this simulation, all bias voltages have been chosen the same and have been systematically varied, and the parasitic capacitances 110 have been simulated as 12μm x 12 μm PN junction capacitances. The results of this simulation are shown in FIG.17, which depicts the efficiency of the voltage conversion circuit of FIG. 16 as a function of the applied bias voltage. This clearly demonstrates that significant improvements of the voltage conversion circuit efficiency can be achieved by applying bias voltages to at least PN diode type parasitic capacitances 110.

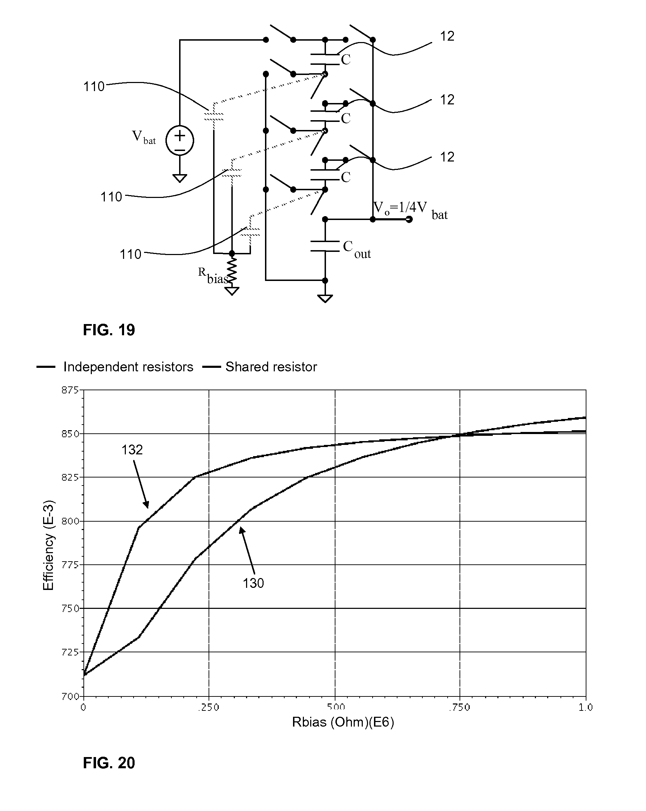

In FIG. 18 and 19, the parasitic capacitances 110 are respectively connected to ground or any biasing voltage source 80. It is reiterated that the parasitic capacitances may be applied independent of a bias voltage source, e.g. via respective resistors $R_{bias}$ (FIG. 18) and a shared resistor $R_{bias}$ (FIG. 19). The parasitic capacitances 110 are again simulated as 12μm x 12 μm PN junction capacitances. The results of these simulations are shown in FIG. 20 in which curve 130 depicts the simulation results of the circuit in FIG. 18 and curve 132 depicts the simulation results of the circuit in FIG. 19. Depicted is the efficiency of the voltage conversion circuit 10 as a function of the value of the applied resistance $R_{bias}$ in ohm. A marked improvement of the efficiency is observed for increasing resistor values.

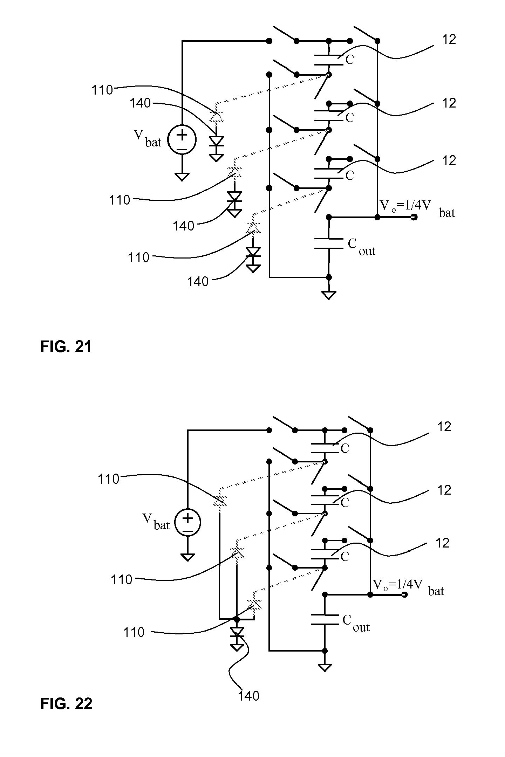

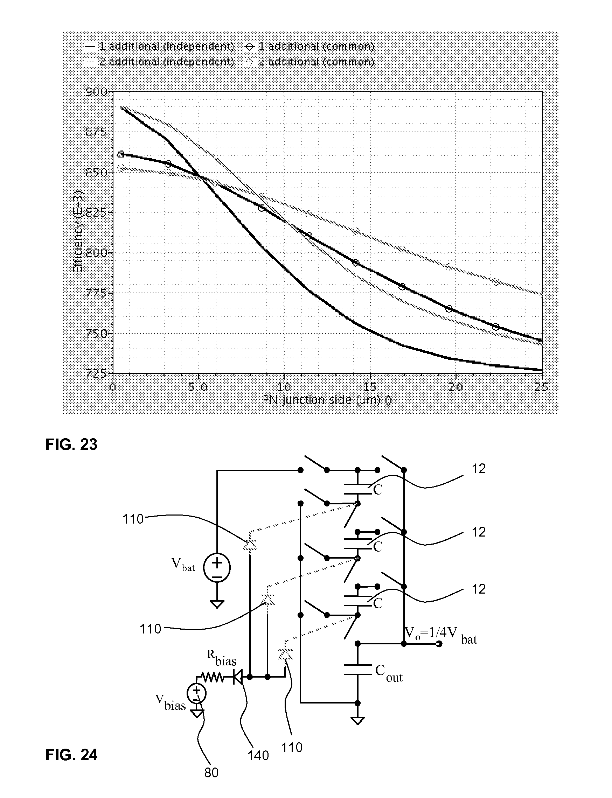

FIG. 21 and 22 depicts embodiments in which the parasitic capacitances 110 are coupled to ground or any biasing voltage source 80 via respective series-connected capacitances 140 (FIG. 21) and a shared series-connected capacitance 140 (FIG. 22) respectively. The parasitic capacitances 110 are again simulated as 12μm x 12 μm PN junction capacitances. The series-connected capacitances are implemented PN junction diodes connected to the parasitic capacitances 110 in a back-to-back fashion. FIG. 23 depicts the efficiency of the circuits of FIG. 21 and 22 as a function of the additional PN junctions side (considered square), in the following cases:

- 1 additional series-connected PN junction diode 140 for each parasitic capacitance 110 (the circuit of FIG. 21);
- 2 additional series-connected PN junction diodes 140 (the second PN junction diode not shown) for each parasitic capacitance 110;
- 1 additional series-connected PN junction diode 140 shared between the parasitic capacitances 110 (the circuit of FIG. 22); and
- 2 additional series-connected PN junction diodes 140 (the second PN junction diode not shown) shared between the parasitic capacitances 110.

As will be apparent from FIG. 23, the size of the PN junction 140 should be kept as small as possible to maximize the efficiency of the voltage conversion circuit 10. This is because the combined capacitance of the parasitic capacitance 110 and the PN junction diode 140 is most effectively reduced this way. It will further be apparent that for larger values of the size of the PN junction diode 140, the provision of multiple additional diodes 140 increases the power efficiency of the voltage conversion circuit 10. It may therefore be beneficial to implement multiple series-connected PN junction diodes 140 in technologies where the minimization of the feature size of the PN junction diode 140 is difficult and/or costly to achieve.

In the embodiment shown in FIG. 24, all main concepts of the present invention have been combined into a single embodiment, i.e. the parasitic capacitances 110 are coupled to the bias voltage source 80 via a series-connected additional capacitance 140 and bias resistor $R_{bias}$. The single common PN junction capacitor 140 has the same size as each of the parasitic capacitances 110, i.e. $12\mu m$ x $12\mu m$.

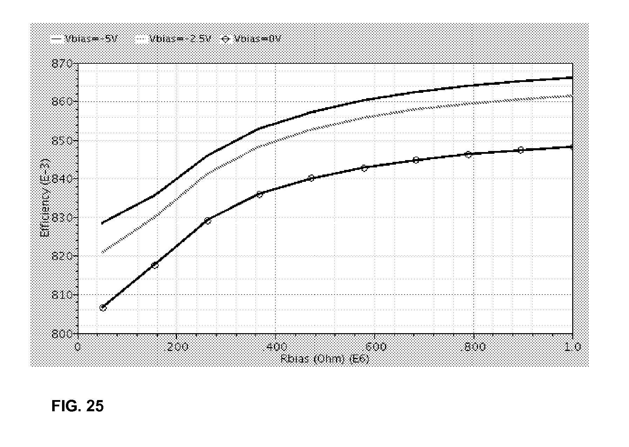

FIG. 25 depicts the efficiency of the voltage conversion circuit 10 as a function of $R_{bias}$ for different values of the bias voltage. It is clearly demonstrated that an increase in $R_{bias}$ as well as $V_{bias}$ further improves the efficiency of the voltage conversion circuit 10.

In summary, the proposed solutions in the present application achieve an improvement of the efficiency of a voltage conversion circuit 10 comprising one or more flying capacitors 12 without requiring any modification of the main operation of the switched-capacitor voltage conversion circuit 10, in contrast to the prior-art solution disclosed by Ramadass et al. Consequently, no impact on any other parameter of the voltage-conversion circuit performance is expected. The only additional cost involves a possible slight increase of the area occupied by the voltage conversion circuit 10 caused by the implementation of the additional components required to increase the impedance between the switching nodes of the flying capacitor(s) of the voltage conversion circuit and the ground potential or any other voltage level, in order to reduce the amount of current flowing from the flying capacitor to the part of the device exhibiting this voltage level.

It should be noted that the above-mentioned embodiments illustrate rather than limit the invention, and that those skilled in the art will be able to design many alternative embodiments without departing from the scope of the appended claims. In the claims, any reference signs placed between parentheses shall not be construed as limiting the claim. The word "comprising" does not exclude the presence of elements or steps other than those listed in a claim. The word "a" or "an" preceding an element does not exclude the presence of a plurality of such elements. The invention can be implemented by means of hardware comprising several distinct elements. In the device claim enumerating several means, several of these means can be embodied by one and the same item of hardware. The mere fact that certain measures are recited in mutually different dependent claims does not indicate that a combination of these measures cannot be used to advantage.

**Claims**

1. A voltage conversion circuit (10) comprising a flying capacitor (12) formed in or on a semiconductor substrate (26), said flying capacitor having a first electrode selectively coupled to an input node for connecting the flying capacitor between different voltage levels ($V_{bat}$; $V_2$) and a second electrode selectively coupled to an output node ($V_{out}$), wherein at least one of the first electrode and the second electrode form a first region of a parasitic capacitance (110), the second region of which is formed by a part (22, 100) of a constant voltage conductor, the voltage conversion circuit further comprising a biasing element (80) for increasing the impedance of the conductive path between the first region and the second region, said biasing element being selected from the group consisting of a bias voltage source, a bias resistor and a series-connected capacitor.

2. The voltage conversion circuit (10) of claim 1, wherein the flying capacitor (12) is formed by a transistor in the substrate (26), said first electrode comprising the gate structure of said transistor and the second electrode comprising the source and drain regions (20; 20') of said transistor.

3. The voltage conversion circuit (10) of claim 1, wherein the flying capacitor (12) is a trench capacitor in said substrate 26).

4. The voltage conversion circuit (10) of claim 3, wherein the second electrode of the trench capacitor comprises a pair of conductive trench layers (62), and wherein the first electrode comprises an intermediate conductive trench layer (62) in between said pair, the conductive trench layers being separated from each other by respective dielectric layers (64).

5. The voltage conversion circuit (10) of claim 1, wherein the flying capacitor (12) is formed in a metallization structure on the substrate, said first and second electrodes being respective metal layers (50; 54) separated by a dielectric layer (52) in said metallization structure.

**6.** The voltage conversion circuit (10) of claim 2 or 5, wherein the biasing element is a bias voltage source, and wherein said part (22, 100) of the substrate (26) is of a first conductivity type, said part being embedded in a further part (24, 26) of the substrate of an opposite conductivity type, wherein the bias voltage source (80) is connected to said further part.

**7.** The voltage conversion circuit (10) of claim 6, further comprising a further bias voltage source (82) connected to said part (22) of the substrate.

**8.** The voltage conversion circuit (10) of any of claims 1-4, wherein the biasing element is a bias voltage source, and wherein said part of the substrate (26) is of a first conductivity type, said part embedding a further part (90) of the substrate, said further part being of an opposite conductivity type, and wherein the bias voltage source (80) is connected to said further part.

**9.** The voltage conversion circuit (10) of any of the preceding claims, wherein the biasing element is a bias voltage source, and wherein said part of the substrate (26) is coupled to the bias voltage source (80) via a resistor ($R_{bias}$).

**10.** The voltage conversion circuit (10) of any of the preceding claims, further comprising at least one additional capacitor (140) connected in series between the parasitic capacitance (110) and the biasing element (80).

**11.** The voltage conversion circuit (10) of any of the preceding claims, wherein the current leakage path exists between the part (24, 100) of the substrate (26) and the second electrode.

**12.** The voltage conversion circuit (10) of any of the preceding claims, comprising a plurality of flying capacitors (12).

**13.** The voltage conversion circuit (10) of claim 12, wherein each flying capacitor (12) is conductively coupled to a part of the substrate via a respective parasitic capacitance (110), and wherein each parasitic capacitance is coupled to a respective biasing element (80).

**14.** An integrated circuit comprising the voltage conversion circuit (10) of any of claims 1-13.

**15.** An electronic device comprising the integrated circuit of claim 14.

FIG. 1

10

FIG. 2

12

FIG. 3

FIG. 4

FIG. 5

**FIG. 6**

**FIG. 7**

FIG. 8

FIG. 9

**FIG. 10**

**FIG. 11**

**FIG. 12**

**FIG. 13**

**FIG. 14**

**FIG. 15**

**FIG. 16**

—— Efficiency

**FIG. 17**

**FIG. 18**

110

$V_{bat}$

110

110

$R_{bias}$

C

C

C

12

12

12

$V_o = 1/4V_{bat}$

$C_{out}$

**FIG. 19**

—— Independent resistors —— Shared resistor

132

130

Efficiency (E-3)

Rbias (Ohm)(E6)

**FIG. 20**

**FIG. 21**

**FIG. 22**

**FIG. 23**

**FIG. 24**

**FIG. 25**

Europäisches
Patentamt

European
Patent Office

Office européen
des brevets

# EUROPEAN SEARCH REPORT

**Application Number**

EP 09 17 1834

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>Y | WO 99/50862 A1 (ASTRA AB [SE]; MARNFELDT GOERAN [SE]) 7 October 1999 (1999-10-07)<br>* claims 1-12 *<br>* figures 1(III), 2a-d *<br>* page 1, lines 11-29 *<br>* page 3, line 27 - page 4, line 17 *<br>----- | 1,5,11,<br>14-15<br>6-10 | INV.<br>H02M3/07<br>H01L21/02<br>H01L29/94 |
| X | US 2006/290413 A1 (AJIKI YOSHIHARU [JP]) 28 December 2006 (2006-12-28)<br>* claims 1-3 *<br>* figures 1,2(A,B),4(A,B) *<br>* paragraphs [0002], [0004], [0006], [0008], [0010], [0014], [0026] - [0045], [0059], [0060] *<br>----- | 1-4,<br>11-15 | |
| Y<br>A | US 2004/196091 A1 (ROSTAING JEAN-PIERRE [FR] ET AL ROSTAING JEAN-PIERRE [FR] ET AL) 7 October 2004 (2004-10-07)<br>* figures 2-4,8 *<br>* paragraphs [0003], [0006], [0008], [0011], [0029], [0030], [0042] - [0045], [0049] - [0052] *<br>----- | 6-10<br><br>1-5,<br>11-15 | |
| A | WO 2008/139392 A2 (NXP BV [NL]; KLOOTWIJK JOHAN H [NL]; BERGVELD HENDRIK J [NL]; ROOZEBOO) 20 November 2008 (2008-11-20)<br>* page 3, paragraph 2 *<br>* page 28, paragraph 2 *<br>----- | 3-4 | TECHNICAL FIELDS SEARCHED (IPC)<br><br>H02M<br>H01L |

The present search report has been drawn up for all claims

| Place of search | Date of completion of the search | Examiner |
|---|---|---|
| The Hague | 3 March 2010 | Kail, Maximilian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
..............................................................................
& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 09 17 1834

This annex lists the patent family members relating to the patent documents cited in the above-mentioned European search report.
The members are as contained in the European Patent Office EDP file on
The European Patent Office is in no way liable for these particulars which are merely given for the purpose of information.

03-03-2010

| Patent document cited in search report | | Publication date | Patent family member(s) | | | Publication date |
|---|---|---|---|---|---|---|
| WO 9950862 | A1 | 07-10-1999 | AU | 3544199 | A | 18-10-1999 |
| | | | CN | 1296630 | A | 23-05-2001 |
| | | | EP | 1084501 | A1 | 21-03-2001 |
| | | | JP | 2002510855 | T | 09-04-2002 |
| | | | US | 2001043114 | A1 | 22-11-2001 |
| US 2006290413 | A1 | 28-12-2006 | JP | 4175393 | B2 | 05-11-2008 |
| | | | JP | 2007036215 | A | 08-02-2007 |
| | | | KR | 20060134867 | A | 28-12-2006 |
| US 2004196091 | A1 | 07-10-2004 | EP | 1398866 | A1 | 17-03-2004 |
| | | | FR | 2844648 | A1 | 19-03-2004 |
| WO 2008139392 | A2 | 20-11-2008 | EP | 2147499 | A2 | 27-01-2010 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2007054858 A2

**Non-patent literature cited in the description**

- **Y.K. Ramadass et al.** Voltage Scalable Switched Capacitor DC-DC Converter for Ultra-Low-Power On-Chip Applications. *IEEE Power Electronics Specialist Conference (PESC),* 2007, 2353-2359